Europäisches Patentamt

European Patent Office

Office européen des brevets

(19)

(11) Veröffentlichungsnummer: **0 158 841**

**A1**

(12) # EUROPÄISCHE PATENTANMELDUNG

(21) Anmeldenummer: 85103049.4

(22) Anmeldetag: 16.03.85

(51) Int. Cl.⁴: **H 03 M 3/04**

(30) Priorität: 30.03.84 CH 1628/84

(43) Veröffentlichungstag der Anmeldung:
23.10.85 Patentblatt 85/43

(84) Benannte Vertragsstaaten:
CH DE FR LI SE

(71) Anmelder: BBC Aktiengesellschaft Brown, Boveri & Cie.
Haselstrasse
CH-5401 Baden(CH)

(72) Erfinder: Lanz, Otto E.
Zweierestrasse 5d
CH-5443 Niederrohrdorf(CH)

(72) Erfinder: Maschek, Martin
Juchstrasse 10
CH-8116 Würenlos(CH)

(72) Erfinder: Mastner, Georg, Dr.
Loonstrasse 5
CH-5443 Niederrohrdorf(CH)

(54) Analog-Digital-Wandler.

(57) Ein erster Diskriminator (7a) vergleicht die Eingangsspannung mit der Ausgangsspannung eines einem digitalen Integrator (1) nachgeschalteten Digital-Analog-Wandlers (3) und bewirkt Vorwärts- oder Rückwärtszählen des digitalen Integrators (1) um ein niedrigstwertiges Bit, falls die Eingangsspannung um mehr als etwa die Hälfte der einem niedrigstwertigen Bit entsprechenden Spannung tiefer oder höher liegt.

Zwecks Verbesserung der Nachführung des digitalen Ausgangssignals bei raschen Schwankungen der Eingangsspannung sprechen zusätzliche Fensterdiskriminatoren (7b, 7c) an, wenn die Eingangsspannung von der Ausgangsspannung des Digital-Analog-Wandlers (3) um mehr als das 10-fache bzw. das 150-fache der einem niedrigstwertigen Bit entsprechenden Spannung abweicht. Sie bewirken dann Vorwärts- oder Rückwärts-Zählen des als dreistufige Kaskade von 4-Bit-Vorwärts-Rückwärts-Zählern (2a, 2b, 2c) ausgebildeten Integrators (1) um ein Bit mit der Wertigkeit $2^4$ bzw. $2^8$.

Der Analog-Digital-Wandler eignet sich besonders zur Verarbeitung des Ausgangssignals eines Strom- oder Spannungs-wandlers.

./...

EP 0 158 841 A1

FIG.1

- 1 -


Analog-Digital-Wandler


Die Erfindung bezieht sich auf einen Analog-Digital-Wandler gemäss dem Oberbegriff des Anspruchs 1.

Es ist ein gattungsgemässer Analog-Digital-Wandler bekannt (US-PS 4 296 412), bei welchem ausschliesslich Nachführungsschritte von einem niedrigstwertigen Bit pro Taktperiode möglich sind. Ein derartiger Analog-Digital-Wandler kann dem analogen Eingangssignal nur folgen, solange dessen Aenderung pro Taktperiode die einem niedrigstwertigen Bit entsprechende Signalgrösse nicht überschreitet. Die letztere kann jedoch, da sie zugleich die Auflösung bestimmt, nicht beliebig gross gemacht werden. Soll insbesondere in einem Teil des Messbereiches oder bei einer bestimmten Signalcharakteristik eine hohe Auflösung erreicht werden, so muss eine unabhängig von den Eigenschaften des Signals stets geringe Nachfolgegeschwindigkeit in Kauf genommen werden.

Aufgabe der Erfindung ist es, einen Analog-Digital-Wandler anzugeben, der geeignet ist, einerseits ein sich verhältnismässig langsam änderndes Eingangssignal mit hoher Auflösung umzusetzen und andererseits rasche Aenderungen
wenigstens qualitativ richtig wiederzugeben.

Diese Aufgabe wird durch die Erfindung, wie sie in den
Ansprüchen gekennzeichnet ist, gelöst.

Die durch die Erfindung erreichten Vorteile sind vor allem
darin zu sehen, dass ohne Einbusse an Auflösung bei langsam veränderlichem Eingangssignal eine rasche und wenigstens qualitativ richtige Erfassung von raschen Aenderungen
möglich ist. Insbesondere können die bei Verwendung eines
erfindungsgemässen Analog-Digital-Wandlers zur Verarbeitung
des Ausgangssignals eines Strom- oder Spannungswandlers,
vor allem, wenn derselbe zugleich Mess- und Schutzzwecken
dienen soll, auftretenden Anforderungen, nämlich genaue
Wiedergabe des ungestörten Signals für Messzwecke und
qualitativ richtige Erfassung von Störungen wie Kurzschlüsse
und schnelle Transienten, mit geringem Schaltungsaufwand
erfüllt werden.

Im folgenden wird die Erfindung anhand einer Zeichnung,
welche nur ein Ausführungsbeispiel darstellt, und einiger
Diagramme näher erläutert.

Es zeigen

Fig. 1 ein Schaltbild eines erfindungsgemässen Analog-
Digital-Wandlers und

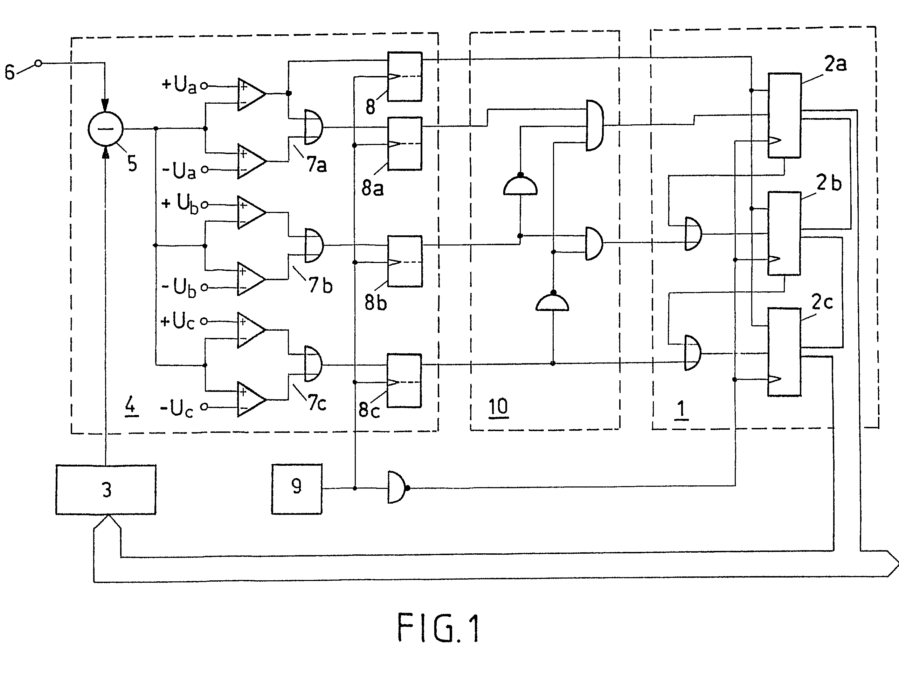

Fig. 2 einen beispielsweisen zeitlichen Verlauf des Eingangssignals und bei dessen Umsetzung durch den
erfindungsgemässen Analog-Digital-Wandler gemäss
Fig. 1 auftretende Signalverläufe und Zählvorgänge.

In seinem grundsätzlichen Aufbau weist der in Fig. 1 dargestellte Analog-Digital-Wandler einen digitalen Integrator 1 auf, der als dreistufige Kaskade von 4-Bit-Vorwärts-Rückwärts-Zählern 2a, b, c realisiert ist, einen dem Integrator 1 nachgeschalteten Digital-Analog-Wandler 3 und einen dem Integrator 1 vorgeschalteten Differenzdiskriminator 4, welcher ein Subtrahierglied 5 enthält, das die Differenz aus der Eingangsspannung an der Eingangsklemme 6 des Analog-Digital-Wandlers und der Ausgangsspannung des Digital-Analog-Wandlers 3 bildet, sowie einen ersten Diskriminator 7a, welcher feststellt, ob besagte Differenz zwischen einem ersten unteren Grenzwert $-U_a$ und einem ersten oberen Grenzwert $+U_a$ liegt und wenn ja, ob sie positiv oder negativ ist. Der Absolutwert $U_a$ der Grenzwerte liegt dabei etwas oberhalb der Hälfte der einem niedrigstwertigen Bit entsprechenden Spannung $\Delta_a$. Zur Zwischenspeicherung der beiden Informationen sind dem ersten Diskriminator 7a zwei D-Flipflops 8, 8a nachgeschaltet. Die Flipflops 8, 8a werden ebenso wie die Vorwärts-Rückwärts-Zähler 2a, b, c von einem Taktgenerator 9 gesteuert.

Erfindungsgemäss weist der Differenzdiskriminator 4 noch zwei weitere als Fensterdiskriminatoren ausgebildete Diskriminatoren 7b, c auf, welche jeweils feststellen, ob die vom Subtrahierglied 5 gebildete Differenz zwischen einem zweiten unteren Grenzwert $-U_b$ und einem zweiten oberen Grenzwert $+U_b$ bzw. zwischen einem dritten unteren Grenzwert $-U_c$ und einem dritten oberen Grenzwert $+U_c$ liegt. Die Absolutwerte $U_b$, $U_c$ der zweiten und dritten Grenzwerte können z.B. das 10-fache und das 150-fache der einem niedrigstwertigen Bit entsprechenden Spannung $\Delta_a$ betragen, d.h. etwas mehr als die Hälfte der einem Bit mit Wertigkeit $2^4$ bzw. $2^8$ entsprechenden Spannungen $\Delta_b$, $\Delta_c$. Den Diskriminatoren 7b, c sind ebenfalls zur Zwischenspeicherung ihrer Ausgangssignale vom Taktgenerator 9 gesteuerte D-Flipflops 8b, c nachgeschaltet.

Zwischen den Differenzdiskriminator 4 und den Integrator 1 ist eine Logikschaltung 10 gelegt, welche von den Ausgangs signalen der Flipflops 8a, 8b und 8c nur das Signal mit der höchsten Priorität an den Integrator weiterleitet und alle Signale niedrigerer Priorität sperrt, wobei 8c die höchste und 8a die niedrigste Priorität haben.

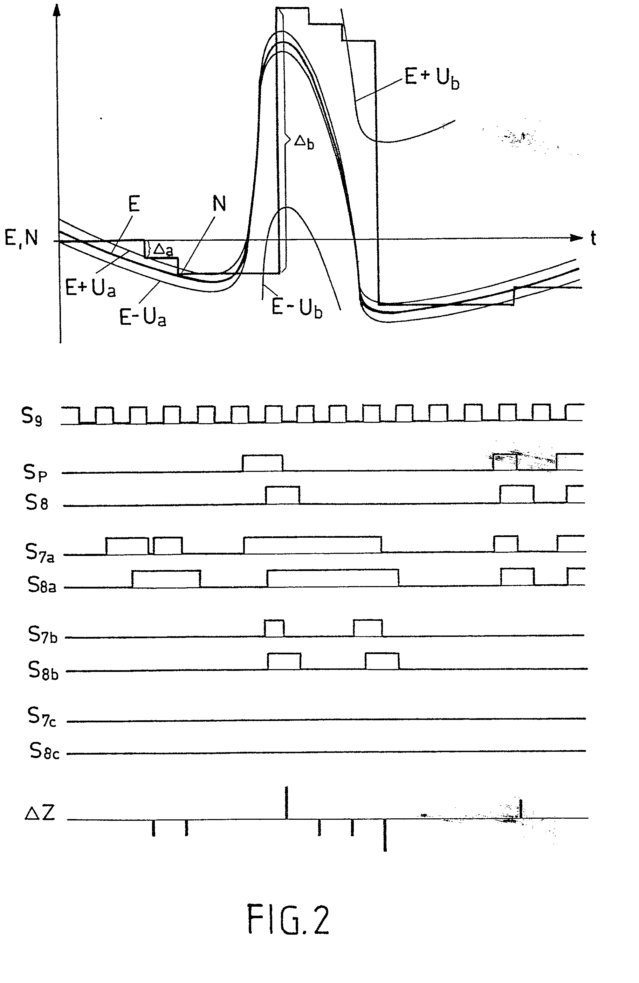

Unter Beiziehung von Fig. 2 soll nun die Funktion des Analog-Digital-Wandlers gemäss Fig. 1 näher erläutert werden.

Sinkt die Eingangsspannung E langsam, bis sie die nachgeführte Spannung N - die analoge Umsetzung des digitalen Ausgangssignals des Analog-Digital-Wandlers, die am Ausgang des Digital-Analog-Wandlers 3 erscheint - um mehr als den ersten Grenzwert $U_a$ unterschreitet, wechselt das Be-reichs-überschreitung anzeigende Ausgangssingal $S_{7a}$ des Diskriminators 7a auf "1", während das Polaritätssignal $S_p$ auf "0" bleibt. Bei der nächsten positiven Flanke des Taktsignals $S_9$ wird das Ausgangssignal $S_{8a}$ des Flipflops 8a auf "1" gesetzt. Da die Ausgangssignale $S_{8b}$, $S_{8c}$ der Flipflops 8b, c "0" sind, wird das "1"-Signal des Flipflops 8a von der Logikschaltung 10 durchgelassen und bildet zusammen mit dem Ausgangssignal $S_8$ des Flipflops 8 ein Nachführsignal, das bei der nächsten negativen Taktflanke die Subtraktion eines niedrigstwertigen Bits vom Zählerstand des Vorwärts-Rückwärts-Zählers 2a und damit des Integrators 1 bewirkt, d.h. die am Ausgang des Analog-Digital-Wandlers liegende Zahl wird um ein niedrigstwertiges Bit erniedrigt. Die Aenderungen besagter Zahl sind im mit $\Delta Z$ bezeichneten Diagramm angedeutet. Die nachgeführte Spannung N ändert sich entsprechend um $-\Delta_a$. Bei langsam steigender Eingangs-spannung E ist der Ablauf analog. Uebersteigt sie die nachgeführte Spannung N um mehr als den ersten Grenzwert $U_a$, so wechselt zusätzlich das die Polarität anzeigende Ausgangssignal $S_p$ des Diskriminators 7a auf "1". Es wird ein niedrigstwertiges Bit addiert anstatt subtrahiert.

Steigt die Eingangsspannung E sehr rasch an, so dass sie die nachgeführte Spannung N um mehr als den zweiten Grenzwert $U_b$ übertrifft, so spricht nach dem Diskriminator 7a, dessen beide Ausgangssignale $S_p$ und $S_{7a}$ auf "1" wechseln, auch der Diskriminator 7b an, und bei der nächsten positiven Taktflanke wechseln die Ausgangssignale $S_8$, $S_{8a}$, $S_{8b}$ der Flipflops 8, 8a, b auf "1". Die von den Signalen $S_8$, $S_{8a}$ und $S_8$, $S_{8b}$ gebildeten Nachführsignale werden von der Logikschaltung 10 verknüpft, die statt des vom Flipflop 8a gelieferten "1"-Signals $S_{8a}$ ein "0"-Signal an den Vorwärts-Rückwärts-Zähler 2a weitergibt. Die Signale $S_8$ und $S_{8b}$ bewirken die Addition eines Bits zum Zählerstand des Vorwärts-Rückwärts-Zählers 2b und damit die Addition einer Nachführungszahl entsprechend einem Bit mit der Wertigkeit $2^4$ zu demjenigen des Integrators 1, d.h. die am Ausgang des Analog-Digital-Wandlers liegende Binärzahl erhöht sich um $2^4$. Entsprechend wechselt die nachgeführte Spannung N um $\Delta_b$, das 16-fache der einem niedrigstwertigen Bit entsprechenden Spannung $\Delta_a$.

Völlig analog ist wiederum der Ablauf, wenn die Eingangsspannung E die nachgeführte Spannung um mehr als den zweiten Grenzwert $U_b$ unterschreitet. Das Ausgangssignal des Flipflops 8 ist dann "0" und die Nachführungszahl wird subtrahiert statt addiert.

Bei noch wesentlich grösseren schnellen Aenderungen der Eingangsspannung E kann dieselbe die nachgeführte Spannung N um mehr als den dritten Grenzwert $U_c$ über- oder unterschreiten, so dass der Diskriminator 7c anspricht, was einen dem obenstehend am Beispiel eines Ansprechens des Diskriminators 7b beschriebenen analogen Ablauf auslöst. Es wird dann der Zählerstand des Vorwärts-Rückwärts-Zählers 2c um ein Bit erhöht oder erniedrigt, d.h. derjenige des Integrators 1 um ein Bit mit der Wertigkeit $2^8$, die nachgeführte Spannung N springt um $\pm\Delta_c$, das 256-fache der einem niedrigstwertigen Bit entsprechenden Spannung $\Delta_a$.

Mit einer mehrstufigen Kaskade von Vorwärts-Rückwärts-Zählern, insbesondere 4 Bit-Vorwärts-Rückwärts-Zählern als digitalem Integrator realisierte erfindungsgemässe Analog-Digital-Wandler, bei welchem jede Nachführungszahl einem Bit an der niedrigsten Stelle eines der Vorwärts-Rückwärts-Zählers entspricht und das Nachführsignal jeweils ein an den entsprechenden Vorwärts-Rückwärts-Zähler geleitetes Zählsignal ist, sind sehr billig und zuverlässig und zur Verarbeitung des Ausgangssignals eines Strom- oder Spannungswandlers sehr gut geeignet. Falls grössere Flexibilität in der Abstufung der Nachführungszahlen erforderlich ist, kann der digitale Integrator z.B. als rückgekoppelter Addierer ausgebildet sein.

Patentansprüche

1. Analog-Digital-Wandler mit einem digitalen Integrator (1), einem dem digitalen Integrator (1) nachgeschalteten Digital-Analog-Wandler (3) und einem dem digitalen Integrator (1) vorgeschalteten Differenzdiskriminator (4), welcher

- einen ersten Diskriminator (7a) enthält, der die Differenz zwischen dem Eingangssignal (E) des Analog-Digital-Wandlers und dem Ausgangssignal (N) des Digital-Analog-Wandlers (3), mit einem positiven ersten oberen Grenzwert ($U_a$) und einem negativen ersten unteren Grenzwert ($-U_a$) vergleicht, deren Absolutwerte zwischen Null und der einem niedrigstwertigen Bit entsprechenden Analogsignalgrösse ($\Delta_a$) liegt, und

- bei Ueberschreiten des ersten oberen Grenzwerts ($U_a$) und bei Unterschreiten des ersten unteren Grenzwerts ($-U_a$) jeweils ein entsprechendes Nachführungssignal ($S_8$, $S_{8a}$) zur Erhöhung bzw. Erniedrigung der am Ausgang des digitalen Integrators (1) liegenden Zahl um eine erste Nachführungszahl, welche den Wert des niedrigstwertigen Bits hat, erzeugt,

dadurch gekennzeichnet, dass der Differenzdiskriminator (4)

- mindestens einen weiteren Diskriminator (7b, 7c) enthält, welcher die Differenz zwischen dem Eingangssignal (E) des Analog-Digital-Wandlers und dem Ausgangssignal (N) des Digital-Analog-Wandlers (9) mit einem weiteren oberen Grenzwert ($U_b$; $U_c$) und mit einem weiteren unteren Grenzwert ($-U_b$; $-U_c$) vergleicht, und

- bei Ueberschreiten des weiteren oberen Grenzwerts ($U_b$; $U_c$) und bei Unterschreiten des weiteren unteren Grenzwerts ($-U_b$; $-U_c$) jeweils ein entsprechendes

Nachführsignal ($S_8$, $S_{8b}$; $S_8$, $S_{8c}$) zur Erhöhung bzw. Erniedrigung der am Ausgang des digitalen Integrators (1) liegenden Zahl um eine weitere Nachführungszahl erzeugt, wobei

- eine weitere Nachführungszahl jeweils grösser ist als die voraufgehende Nachführungszahl,
- die Absolutwerte der Grenzwerte ($U_b$, $-U_b$; $U_c$, $-U_c$) eines weiteren Diskriminators (7b; 7c) jeweils zwischen der der voraufgehenden Nachführungszahl entsprechenden Analogsignalgrösse ($\Delta_a$; $\Delta_b$) und der der weiteren Nachführungszahl entsprechenden Analogsignalgrösse ($\Delta_b$; $\Delta_c$) liegt, und
- zwischen dem Differenzdiskriminator (4) und dem digitalen Integrator (1) eine Logikschaltung (10) liegt, welche jeweils nur das der höchsten Nachführungszahl entsprechende der vom Differenzdiskriminator (4) erzeugten Nachführsignale ($S_8$, $S_{8a}$; $S_8$, $S_{8b}$; $S_8$, $S_{8c}$) durchlässt.

2. Analog-Digital-Wandler nach Anspruch 1, dadurch gekennzeichnet, dass sich eine weitere Nachführungszahl von der voraufgehenden Nachführungszahl jeweils um einen Faktor unterscheidet, der eine ganzzahlige Potenz von zwei ist.

3. Analog-Digital-Wandler nach Anspruch 2, dadurch gekennzeichnet, dass der digitale Integrator (1) als mehrstufige Kaskade von Vorwärts-Rückwärts-Zählern (2a, 2b, 2c) ausgebildet ist, jede Nachführungszahl einem Bit an der niedrigsten Stelle eines der Vorwärts-Rückwärts-Zähler (2a; 2b; 2c) entspricht und das entsprechende Nachführsignal ($S_8$, $S_{8a}$; $S_8$, $S_{8b}$; $S_8$, $S_{8c}$) jeweils ein an den entsprechenden Vorwärts-Rückwärts-Zähler (2a; 2b; 2c) geleitetes Zählsignal ist.

4. Analog-Digital-Wandler nach einem der Ansprüche 1 bis 3, **dadurch gekennzeichnet, dass** die weiteren Diskriminatoren (7b, 7c) im Differenzdiskriminator (4) Fensterdiskriminatoren sind und nur der erste Diskriminator (7a) zur Feststellung der Polarität geeignet ist.

FIG.1

FIG.2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl.4) |
|---|---|---|---|
| Y | PROCEEDINGS OF THE NATIONAL ELECTRONICS CONFERENCE, Band XV, Oktober 1959, Seiten 182-194, Chicago, US; R.C. PLATZEK u.a.: "A high-speed, electronic analog-to-digital encoder" * Seite 185, letzter Abschnitt - Seite 186, Zeile 2; Figur 1 * | 1 | H 03 M 3/04 |
| A | Idem | 3 | |
| | --- | | |
| Y | GB-A-2 101 435 (DINDIMA) * Seite 2, Zeilen 46-80; Seite 4, Zeilen 84-103 * | 1 | |
| A | | 4 | |
| | --- | | RECHERCHIERTE SACHGEBIETE (Int. Cl 4) |
| A | US-A-3 922 619 (THOMPSON) * Spalte 3, Zeilen 38-50 * | 2 | H 03 M<br>H 04 B |
| | ----- | | |

Der vorliegende Recherchenbericht wurde für alle Patentansprüche erstellt.

| Recherchenort DEN HAAG | Abschlußdatum der Recherche 09-07-1985 | Prüfer HOLPER G.E.E. |
|---|---|---|